(19) **Europäisches Patentamt**

**European Patent Office**

**Office européen des brevets**

(11) **EP 0 753 892 B1**

(12) **EUROPEAN PATENT SPECIFICATION**

(45) Date of publication and mention
of the grant of the patent:
**10.04.2002 Bulletin 2002/15**

(51) Int Cl.7: **H01L 27/02**

(21) Application number: **96111201.8**

(22) Date of filing: **11.07.1996**

(54) **Semiconductor device including protection means**

Halbleiteranordnung mit einer Schutzvorrichtung

Dispositif semi-conducteur comprenant des moyens de protection

(84) Designated Contracting States:
**DE FR GB IT NL**

(30) Priority: **11.07.1995 US 1054**

(43) Date of publication of application:
**15.01.1997 Bulletin 1997/03**

(73) Proprietor: **TEXAS INSTRUMENTS
INCORPORATED**
**Dallas Texas 75265 (US)**

(72) Inventors:
• **Amerasekera, E. Ajith
Plano, TX 75023, (US)**
• **Duvvury, Charvaka,
Plano, TX 75025, (US)**

(74) Representative:
**Schwepfinger, Karl-Heinz, Dipl.-Ing.
Prinz & Partner GbR
Manzingerweg 7
81241 München (DE)**

(56) References cited:
**EP-A- 0 084 177        EP-A- 0 404 008
EP-A- 0 546 698        US-A- 5 290 724**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

FIELD OF THE INVENTION

This invention generally relates to semiconductor devices and processes and more specifically to ESD protection in CMOS integrated circuits.

BACKGROUND OF THE INVENTION

As integrated circuits (ICs) become more complex and more dense, the nominal supply voltage drops. Whereas, once nominal supply voltages were in the 5V range and then the 3.3V range, state of the art ICs today have a nominal supply voltage of approximately 2.5 V. However, these ICs must operate in systems designed for older ICs having a 3.3V nominal supply voltage. Thus, today's ICs are expected to be able to sustain 3.3 V at the input/output (I/O) pins without excessive leakage or any permanent damage occurring. However, since a gate oxide of the order of 60 A is used in the newer ICs, there is a possibility of reliability problems related to gate oxide wear-out based on time dependent dielectric breakdown analysis. In addition, the ICs are expected to be power-up sequence independent. That is, when the supply voltage is at 0 V, the IC needs to be able to tolerate 3.6 volts at the I/O pins without permanent damage or excessive oxide stressing.

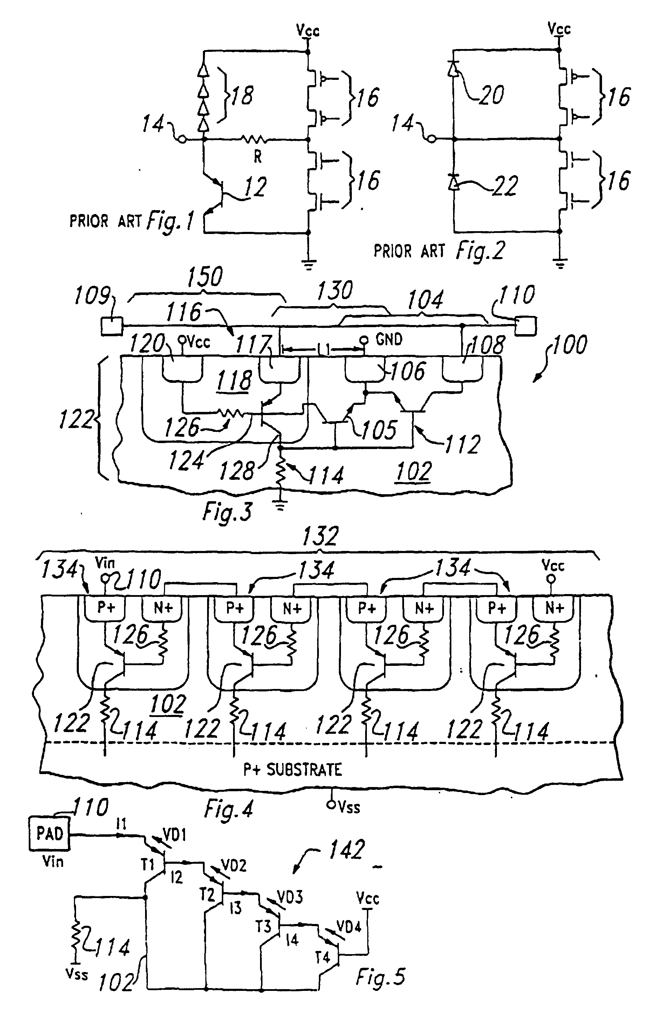

These requirements place major restrictions on the electrostatic discharge (ESD) protection circuit design. Gate oxides cannot be connected directly between the I/O pads and ground. Thus, typical ESD protection circuits such as the gate-coupled nMOS transistor, low voltage triggered SCRs (silicon-controlled rectifiers) and gate-coupled SCRs cannot be used as they have been in the past. One prior art technique that avoids connecting a gate oxide directly between the internal circuitry at the I/O pins and ground in a modified lateral SCR (MLSCR), is shown in Figure 1. The MLSCR 12 is connected between the I/O pin 14 and ground GND. Unfortunately, the trigger voltage of the MLSCR (about 20V) is higher than the breakdown of a gated-diode junction (typically between 8V and 10V) or a gate oxide (typically about 12V - 15V). Hence, a series resistor R is required to enable the voltage at the anode of the MLSCR 12 to reach the SCR trigger level before the internal circuitry 16 is damaged.

Another ESD protection circuit that avoids connecting a gate-oxide directly between the internal circuitry at the I/O pins and ground is a dual-diode circuit, shown in Figure 2. A first diode 20 is connected between the I/O pin 14 and the supply voltage, Vcc and a second diode 22 is connected between I/O pin 14 and ground, GND. However, this circuit has limitations in submicron devices. The voltage-clamping properties of a reversed biased n+/p diode is one limitation. The on-resistance of a reversed-biased diode in avalanche breakdown is greater than 25 ohms. This limits the capability of high current clamping. Accordingly, there is a need for an improved ESD protection circuit that avoids connecting a gate oxide between internal circuitry and ground.

US-A-5 290 724 discloses an ESD protection circuit comprising a lateral npn transistor for which a substrate serves as a base, and a substrate biasing circuit for triggering the lateral npn transistor by increasing a voltage across the substrate resistance during an ESD event. The pre-characterizing part of claim 1 is based on the prior art contained in this document.

SUMMARY OF THE INVENTION

An ESD protection circuit and method for integrated circuits is described herein. A lateral npn transistor is connected between an I/O pad and ground. A substrate biasing circuit is provided that causes current to be conducted through the substrate resistance during an ESD event. This, in turn, raises the voltage across the substrate resistance and forward-biases the emitter-base junction of the lateral npn thus triggering the lateral npn. The lateral npn is the primary protection device for dissipating ESD current.

An advantage of the invention is providing improved ESD protection for multi-voltage applications in submicron, thin oxide CMOS processes.

A further advantage of the invention is providing improved ESD protection for multi-voltage applications that is independent of the power-up sequence in submicron, thin oxide CMOS processes.

A further advantage of the invention is providing improved ESD protection requiring less area in submicron, thin oxide CMOS processes.

These and other advantages will be apparent to those skilled in the art having reference to the specification in conjunction with the drawings.

BRIEF DESCRIPTION OF THE DRAWINGS

The present invention will now be further described by way of example, with reference to the accompanying drawings in which;

FIG. 1 is a schematic diagram of a prior art ESD protection circuit;

FIG. 2 is a schematic diagram of a prior art dual-diode ESD protection circuit;

FIG. 3 is a partially cross-section/partly schematic diagram of an ESD protection device according to one embodiment of the invention;

FIG. 4 is a partially cross-section/partly schematic diagram of an ESD protection device according to the invention having a diode string;

FIG. 5 is a schematic diagram of an ESD protection device according to the invention including a Darlington circuit;

FIG. 6 is a graph of applied voltage versus number of diodes for various vertical pnp transistor gains;

FIG. 7 is a schematic diagram of an ESD protection device according to the invention including a snubber circuit for reducing reverse leakage current;

FIG. 8 is a schematic diagram of an ESD protection device according to the invention including emitter base resistors in a Darlington circuit for increasing the maximum clamp voltage and reducing the reverse leakage current;

FIG. 9 is a schematic diagram of an ESD protection device according to the invention illustrating a Darlington circuit and multiple lateral npn transistors;

FIG. 10 is a exemplary layout diagram of an ESD protection device according to the invention;

FIG. 11 is a preferred layout of an ESD protection device according to the invention;

Corresponding numerals and symbols in the different figures refer to corresponding parts unless otherwise indicated.

DETAILED DESCRIPTION OF PREFERRED EMBODIMENTS

An ESD protection device 100 according to the invention is shown in Figure 3. A lateral npn transistor 104 is located in a substrate layer 102. Substrate layer 102 may, for example, comprise a p-type epitaxial layer on a p+ substrate. Lateral npn 104 comprises two n-type diffused regions 106,108 as the emitter and collector respectively. Diffused regions 106 and 108 are preferably separated by the minimum spacing allowed by design rules, for example of the order of 0.7 μm. Diffused region 106 (the emitter) is connected to ground and diffused region 108 (the collector) is connected to the I/O pad 110. The base 112 is connected to ground through the substrate 102 and its associated resistance 114.

Substrate biasing circuit 150 raises the voltage across the substrate resistance 114 during an ESD event. This, accordingly, raises the voltage at the base of lateral npn 104 to forward bias the emitter-base junction and trigger the npn transistor 104. The npn transistor 104 clamps the voltage at the pad 110 to a voltage of the order of 5-7 volts and dissipates the ESD current. Thus, the internal circuitry 109 is protected.

Substrate biasing circuit 150, in the embodiment shown in Figure 3, comprises a diode 116. Diode 116 comprises a p-type diffused region 117 within n-well 118. P-type diffused region 117 is connected to the I/O pad 110. The supply voltage Vcc is connected to n-well 118 through n-type diffused region 120. Diode 116 thus comprises an inherent vertical pnp transistor 122. Vertical pnp transistor 122 is not a discrete element but is automatically built-in to diode 116 within n-well 118. P-type diffused region 117 forms the emitter of the inherent vertical pnp transistor 122 and the base 124 is connected to the supply voltage Vcc through the n-well 118 resistance 126 and n-type diffused region 120. The collector 128 is connected through the substrate resistance 114 to ground, GND. An advantage of the invention is that it is applicable to CMOS processes without additional masking steps. Alternative substrate biasing circuits will be apparent to those skilled in the art having reference to the specification.

Operation of the above described circuit under ESD conditions will now be described. At a first stage of operation, the voltage at I/O pad 110 reaches the turn-on voltage of vertical pnp 122. This may be on the order of 0.8 V. ESD current then begins to conduct through vertical pnp transistor 122. This raises the voltage across the substrate resistance 114 and accordingly at the base of lateral npn transistor 104. In the second stage of operation, the voltage at the base of lateral npn transistor 104 eventually rises enough to forward bias the emitter-base junction, triggering the npn transistor 104. The clamping voltage of the lateral npn transistor 104 is the same as the snapback voltage of a lateral field oxide MOS device (i.e., of the order of 5-7 V). At this point, the majority of the current dissipates through lateral npn transistor 104. In the last stage of operation, an inherent SCR 130 created by n-type diffused region 106, the substrate 102, the n-well 118 and p-type diffused region 117 triggers providing a second voltage clamp. The spacing L1 between the anode (p-type diffused region 117) and cathode (n-type diffused region 106) of the SCR 130 determines the holding voltage of the SCR 130. This is preferably greater than the burn-in voltage and for accelerated reliability testing of about 4V in an advanced CMOS process. The burn-in voltage may for example be of the order of 4.5V. The SCR 130 is also triggered by the vertical pnp transistor action. The collector current through the p-substrate 102 enables the cathode (n-type diffused region 106) to substrate 102 junction to forward bias triggering an inherent lateral npn transistor 105 and then the inherent SCR 130. The SCR 130 is preferably designed so that once the SCR 130 triggers, the voltage clamps to greater than 4V.

Because the ESD protection device 100 according to the invention does not comprise a thin gate oxide, there are no gate oxide integrity problems associated with multi-voltage operation. Multi-voltage operation occurs when the voltage at the I/O pad 110 can be higher than the designed for supply voltage Vcc. For example, the device is fabricated for 2.5V operation but in operation receives I/O signals ranging from 0 to 3.3 V. Receiving a higher voltage at the I/O pad 110 than the supply voltage Vcc (i.e., 3.3V for a 2.5 V device) does not stress the protection device 100. Furthermore, the ESD protection device 100 is independent of power-up sequence. That is, the device 100 is not stressed when a high signal (i.e., 3.3V) is applied at the I/O pad 110 while the supply voltage Vcc remains at 0V.

In the preferred embodiment of the invention, diode 116 actually comprises a diode string 132 as shown in Figure 4 in order to increase the clamping voltage at the pad for input voltages greater than Vcc. Diode string 132 is connected between the I/O pad 110 and the supply voltage, Vcc. The pn diodes 134 are lateral elements in that the dominant current flow is lateral. However, as shown in Figure 5 and described above, the lateral pn diode actually forms the emitter-base junction of a vertical pnp transistor 122 with the p-type substrate 102 serving as the collector. This creates a multi-stage pnp Darlington circuit 142 as shown in Figure 5. Figure 5 illustrates a four-stage pnp Darlington circuit 142 having four inherent vertical pnp transistors T1-T4. The emitter of the Darlington circuit 142 is connected to the I/O pad 110, the collector is the substrate 102, and the base is connected to the supply voltage Vcc.

The equation governing the total voltage, $V_{IN}$ across the Darlington circuit is easily determined by considering the gain, $\beta$ and the forward voltage drop, $V_D$, across the base-emitter junction of each *pnp* transistor as indicated in Figure 5.

The current, $I_1$, in the first transistor, *T1*, is given by,

$$I_1 = I_0 \exp\left(\frac{qV_{D1}}{kT}\right)$$

$I_0$ is the saturation current across the $p^+/n$ junction and $V_{D1}$ is the voltage drop across the base-emitter junction. Similarly the current, $I_2$, in the second transistor, $T_2$, is given by,

$$I_2 = I_0 \exp\left(\frac{qV_{D2}}{kT}\right)$$

For $\Delta V = (V_{D1} - V_{D2})$,

$$\frac{I_1}{I_2} = \exp\left(\frac{q\Delta V}{kT}\right)$$

or,

$$\Delta V = \frac{kT}{q} \ln\left(\frac{I_1}{I_2}\right)$$

$$\Delta v = \frac{kT}{q} \ln (1+\beta),$$

since $I_1 = (1 +\beta) I_2$. Hence, it can be shown that for a string of n transistors,

$$V_{IN} = nV_{D1} - \frac{n(b-l)}{2} \frac{kT}{q}\ln(l+\beta).$$

This equation is valid for $n \leq V_A/[kTln(I_1/I_0)]$, that is for $V_{D1} = V_A/n$. It must be noted that it is assumed that $\beta$ is independent of current in this equation for simplified analysis.

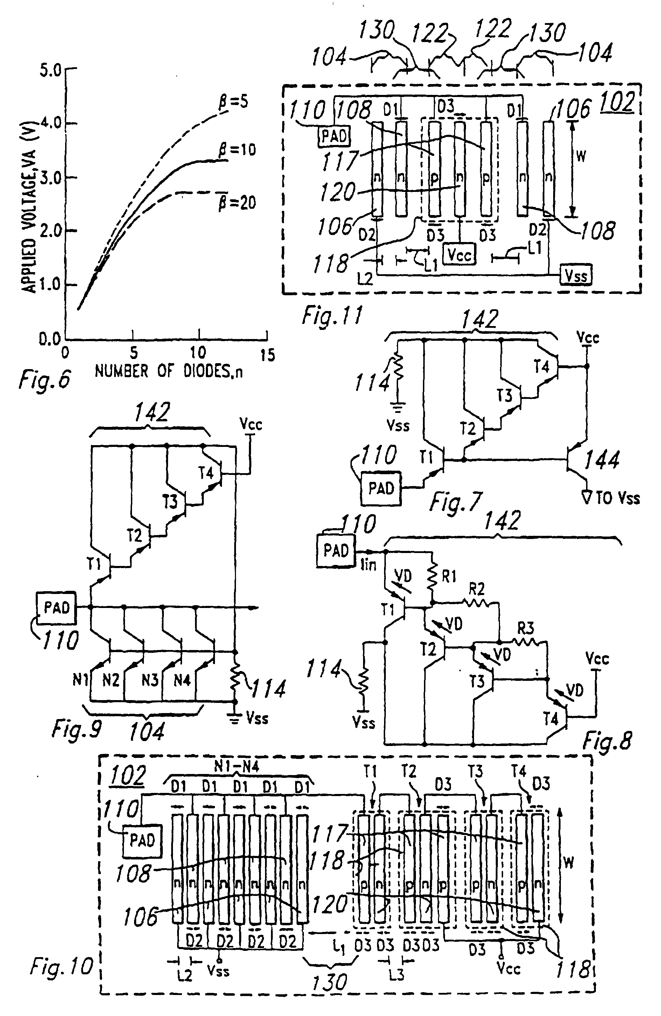

The equation indicates that because of the gain, $\beta$, of the vertical pnp, the voltage drop will not be equal across each diode, and beyond a certain n there will no longer be any diode current. The maximum number of diodes that can successfully be used in series is determined by the gain, $\beta$, of the *pnp*. Assuming $V_{D1}$ = 0.6 V, a plot of the maximum $V_A$ as a function of the number of diodes is shown in Figure 6 for $\beta$ of 5, 10 and 20. For a gain, $\beta$, of 10, the maximum voltage clamp for a straight diode string is $\approx$ 3.3 V, and for a $\beta$ of 5, a 4 V clamp is achieved with an 11 diode string. The maximum $V_A$ occurs for strings of > 12 diodes.

It should be noted that in a high gain process, the emitter areas of the different stages need not be the same. Since the current decreases in the stages closer to $V_{cc}$ these transistors can have proportionately smaller areas.

If desired, a snubber circuit may be used to reduce the reverse leakage current between Vcc and the pad in normal operation. For example, a snubber transistor 144 may be placed between the base of the first stage of the Darlington circuit 142 and the base of the final stage as shown in Figure 7. The purpose of the snubber transistor 144 is to clamp the voltage at the base of the first stage to that of one forward biased diode below the supply voltage Vcc. This snubs the other pnp stages until the voltage at the I/O pad 110 exceeds the supply voltage, Vcc.

Optional feed-forward resistors R1-R3 may be placed between the different diodes of the Darlington circuit 142 as shown in Figure 8 to increase the clamping voltage onto the pad and reduce the reverse leakage current. Resistors R1-R3 increase the clamping voltage by ensuring that transistors closer to Vcc are turned on. In addition, without resistors R1-R3, the first stages of the Darlington circuit 142 carry most of the current and the later stages may not turn on. Resistors R1-R3 allow current to flow in parallel with each of the Darlington stages and control the voltage drop across each stage.

For an equal voltage drop across each stage, the resistors are proportioned as R, R/2, R/3, ..., R/(n-1) for n stages. For example, for a 1 mA current limit at the I/O pad 110 and a 6 diode string with a resistor across every two diodes, R is 2 kΩ.

As shown in Figure 9, lateral npn transistor 104 can also comprise a plurality of lateral npn transistors transistor N1-N4. The base of each lateral npn N1-N4 is connected to the substrate resistance 114. Each emitter is connected to ground (Vss) and each collector is connected to I/O pad 110.

An exemplary layout for the invention is shown in Figure 10. The layout of Figure 10 assumes a four stage Darlington circuit. However, those skilled in the art will realize that the number of stages may vary. The lateral npn transistors N1-N4 are formed using n-type diffused regions 106,108 within substrate 102. The n-type diffused regions 106 and 108 alternate between connecting to ground Vss (n-type diffused regions 106) and the I/O pad 110 (n-type diffused regions 108). The spacing L2 between diffused regions 106 and 108 is preferably the minimum allowed by the design rules (i.e., of the order of 0.7 µm). Each diffusion width, D1 and D2 is of the order of 3 µm.

The diodes 134/pnp transistors T1-T4 are each formed in a separate well regions 118 using one p-type diffused region 117 and one n-type diffused region 120 in each well region 118. The p-region 117 of the first pnp transistor stage T1 is connected to the I/O pad 110. The n-region 120 is connected to the p-region 117 of the second stage T2. The n-region 120 of the second stage T2 is then connected to the p-region 117 of the third stage T3 and so on until the last stage T4. The n-region 120 of the last stage T4 is connected to the supply voltage Vcc. The n-well to n-well spacing may be the minimum allowed to conserve area, for example 3 µm. The p- and n- diffused region widths D3 may be of the order of 5 microns and the spacing L1 between the p-type diffused region 117 of the first stage and the nearest n-type diffused region 106 may be on the order of 3.5 µm. It is this spacing that determines the holding voltage of the SCR 130. The width W may be of the order of 70 µm. An advantage of the invention is that it requires only a small area (i.e., approximately 5000 µm² using sub-0.5µ design rules). For example, the layout of Figure 10 results in an area of the order of 5600 µm.

A preferred layout for a vertical pnp triggered ESD protection circuit according to the invention is shown in Figure 11. The lateral npn transistors 104 are formed using n-type diffused regions 106,108 within substrate 102. The n-type diffused regions 106 and 108 alternate between connecting to ground Vss (n-type diffused regions 106) and the I/O pad 110 (n-type diffused regions 108). The spacing L2 between diffused regions 106 and 108 is preferably the minimum allowed by the design rules (i.e., of the order of 0.7 µm). Each diffusion width, D1 and D2 is of the order of 3 µm. Two diodes/ vertical pnp transistors 122 are formed in well regions 118 using two p-type diffused regions 117 and one n-type diffused region 120. The p-regions 117 are connected to the I/O pad 110. The n-region 120 is connected to Vcc. The p- and n-diffused region widths D3 may be of the order of 5 µm and the spacing L1 between the p-type diffused region 117 and the nearest n-type diffused region 106 may be of the order of 3.5 µm. It is this spacing that determines the holding voltage of the SCR 130. The width W may be of the order of 70 µm.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description.

**Claims**

1. An ESD protection circuit formed in a substrate (102) comprising:

   at least one lateral npn transistor (104) for which said substrate (102) serves as a base (112), wherein said at least one lateral npn transistor (104) is connected between an input/output pad (110) and ground and said substrate (102) is connected to ground; and
   a substrate biasing circuit (150) for triggering the or each lateral npn transistor (104) by increasing a voltage across the substrate resistance (114) during an ESD event, said circuit **being characterized in that**
   said substrate biasing circuit (150) comprises a Darlington string of diodes (132, 142) connected between an input/output pad (110) and a supply voltage (Vcc), wherein at least one diode in said Darlington string of diodes (132, 142) includes an inherent vertical pnp transistor (122) having a collector (128) which is connected to a base (112) of said lateral npn transistor (104) for triggering said lateral npn transistor (104) through the substrate resistance (114).

2. The ESD protection circuit of claim 1, wherein said at least one diode (116) comprises:

   a p-type diffused region (117) located within a well region (118) and connected to an input/output pad (110); and
   a n-type diffused region (120) located within said well region (118) and connected to a supply voltage (Vcc).

3. The ESD protection circuit of claim 2, further comprising at least one inherent silicon-controlled rectifier (SCR) (130) formed of said p-type diffused region (117), said well region (118), said substrate (102), and an emitter region (106) of said lateral npn transistor (104).

4. The ESD protection circuit of any preceding claim, wherein said lateral npn transistor (104) comprises an emitter (106) connected to a ground potential and a collector (108) connected to an input/output pad (110).

5. The ESD protection circuit of any preceding claim, further comprising: a plurality of npn transistors (104) each having a collector connected to said input/output pad (110), an emitter connected to a ground potential, and a base connected to said ground potential through an inherent resistance (114) in said substrate.

6. The ESD protection circuit of any preceding claim, further comprising: a reverse diode connected in parallel with said Darlington string of diodes (142) for leakage reduction, wherein said reverse diode is part of a transistor (144).

7. The ESD protection circuit of any preceding claim, further comprising: at least one resistor (R1, R2, R3) connected between an emitter and base of at least one diode in said Darlington string of diodes (142).

8. The ESD protection circuit of any preceding claim, wherein said Darlington string of diodes (142) comprises between 2 and 12 diodes.

9. The ESD protection circuit of any of claims 5 to 8, wherein
said plurality of lateral npn transistors each includes a diffused emitter region (106) connected to ground potential and a diffused collector region (108) connected to an input/output pad (110).

10. The ESD protection circuit of any preceding claim, wherein each of said diodes (116) in said Darlington string (142) comprises an inherent vertical pnp transistor (122).

11. The ESD protection circuit of claim 10, wherein each of said diodes in said Darlington string (142) comprises:

a n-type well region (118) located in said substrate (102), said n-type well region (118) forming a base region (128) of said inherent vertical pnp transistor (122);
a n-type diffused region (120) within said n-type well region (118) for providing a connection to said base region (128) of said inherent vertical pnp transistor (122); and

a p-type diffused region (117) within said n-type well region (118), said p-type diffused region (117) forming an emitter region of said inherent vertical pnp transistor (122).

12. The ESD protection circuit of claims 9 to 11, further comprising at least one inherent silicon-controlled rectifier (SCR) (130) formed of said p-type diffused region (117) and said well region (118) of one of said diodes in said Darlington string (142), said substrate (102), and a diffused emitter region (106) of one of said plurality of lateral npn transistors (104).

13. The ESD protection circuit of any of claims 9 to 12, further comprising a reverse diode connected in parallel with said diodes in said Darlington string (142), wherein said reverse diode is part of a transistor (144).

14. The ESD protection circuit of any of claims 9 to 13, further comprising at least one resistor (R1, R2, R3) connected between said n-type diffused region (120) and said p-type diffused region (117) of at least one diode of said Darlington string (142) for balancing the current in said diodes of said Darlington string of diodes (142) and for increasing the clamp voltage for mixed voltage operation.

**Patentansprüche**

1. ESD-Schutzschaltung, die in einem Substrat (102) ausgebildet ist, mit:

mindestens einem lateralen npn-Transistor (104), für den das Substrat (102) als eine Basis (112) dient, wobei der mindestens eine laterale npn-Transistor (104) zwischen eine Ein-/Ausgabekontaktstelle (110) und Masse geschaltet ist und wobei das Substrat (102) an Masse gelegt ist, und

einer Substrat-Vorspannungsschaltung (150) zum Triggern des oder jedes lateralen npn-Transistors (104) durch Erhöhen einer Spannung am Substratwiderstand (114) während eines ESD-Ereignisses,

**dadurch gekennzeichnet, daß**
die Substrat-Vorspannungsschaltung (150) eine Darlington-Diodenkette (132, 142) aufweist, die zwischen eine Ein-/Ausgabekontaktstelle (110) und eine Versorgungsspannung (Vcc) geschaltet ist, wobei mindestens eine Diode in der Darlington-Diodenkette (132, 142) einen inhärenten vertikalen pnp-Transistor (122) mit einem Kollektor (128) aufweist, der an eine Basis (112) des lateralen npn-Transistors (104) angeschlossen ist, um den lateralen npn-Transistor (104) über den Substratwiderstand (114) zu triggern.

**2.** ESD-Schutzschaltung nach Anspruch 1, wobei die mindestens eine Diode (116) aufweist:

eine p-diffundierte Zone (117), die sich innerhalb einer Wannenzone (118) befindet und an eine Ein-/Ausgabekontaktstelle (110) angeschlossen ist, und

eine n-diffundierte Zone (120), die sich innerhalb der Wannenzone (118) befindet und an die eine Versorgungsspannung (Vcc) angelegt ist.

**3.** ESD-Schutzschaltung nach Anspruch 2, welche weiter mindestens einen inhärenten Thyristor (SCR) (130) aufweist, der aus der p-diffundierten Zone (117), der Wannenzone (118), dem Substrat (102) und einer Emitterzone (106) des lateralen npn-Transistors (104) besteht.

**4.** ESD-Schutzschaltung nach einem der vorhergehenden Ansprüche, wobei der laterale npn-Transistor (104) einen auf ein Massepotential gelegten Emitter (106) und einen an eine Ein-/Ausgabekontaktstelle (110) angeschlossenen Kollektor (108) aufweist.

**5.** ESD-Schutzschaltung nach einem der vorhergehenden Ansprüche, weiter aufweisend: mehrere npn-Transistoren (104), die jeweils einen an die Ein- /Ausgabekontaktstelle (110) angeschlossenen Kollektor, einen auf ein Massepotential gelegten Emitter und eine über einen inhärenten Widerstand (114) in dem Substrat auf das Massepotential gelegte Basis aufweisen.

**6.** ESD-Schutzschaltung nach einem der vorhergehenden Ansprüche, weiter aufweisend: eine parallel zur Darlington-Diodenkette (142) geschaltete Rückspeisediode zur Leckverringerung, wobei die Rückspeisediode Teil eines Transistors (144) ist.

**7.** ESD-Schutzschaltung nach einem der vorhergehenden Ansprüche, weiter aufweisend: mindestens einen zwischen einen Emitter und eine Basis von mindestens einer Diode in der Darlington-Diodenkette (142) geschalteten Widerstand (R1, R2, R3).

**8.** ESD-Schutzschaltung nach einem der vorhergehenden Ansprüche, wobei die Darlington-Diodenkette (142) zwischen 2 und 12 Dioden aufweist.

**9.** ESD-Schutzschaltung nach einem der Ansprüche 5 bis 8, wobei
die mehreren lateralen npn-Transistoren jeweils eine auf das Massepotential gelegte diffundierte Emitterzone (106) und eine an eine Ein-/Ausgabekontaktstelle (110) angeschlossene diffundierte Kollektorzone (108) aufweisen.

**10.** ESD-Schutzschaltung nach einem der vorhergehenden Ansprüche, wobei jede der Dioden (116) in der Darlington-Kette (142) einen inhärenten vertikalen pnp-Transistor (122) aufweist.

**11.** ESD-Schutzschaltung nach Anspruch 10, wobei jede der Dioden in der Darlington-Kette (142) aufweist:

eine n-Wannenzone (118), die in dem Substrat (102) angeordnet ist und die eine Basiszone (128) des inhärenten vertikalen pnp-Transistors (122) bildet,

eine n-diffundierte Zone (120) innerhalb der n-Wannenzone (118) zum Bereitstellen einer Verbindung mit der Basiszone (128) des inhärenten vertikalen pnp-Transistors (122) und

eine p-diffundierte Zone (117) innerhalb der n-Wannenzone (118), wobei die p-diffundierte Zone (117) eine Emitterzone des inhärenten vertikalen pnp-Transistors (122) bildet.

**12.** ESD-Schutzschaltung nach Anspruch 9 bis 11, welche weiter mindestens einen inhärenten Thyristor (SCR) (130) aufweist, der aus der p-diffundierten Zone (117) und der Wannenzone (118) von einer der Dioden in der Darlington-Kette (142), dem Substrat (102) und einer diffundierten Emitterzone (106) von einem der mehreren lateralen npn-Transistoren (104) besteht.

**13.** ESD-Schutzschaltung nach einem der Ansprüche 9 bis 12, welche weiter eine parallel zu den Dioden in der Darlington-Kette (142) geschaltete Rückspeisediode aufweist, wobei die Rückspeisediode Teil eines Transistors (144) ist.

**14.** ESD-Schutzschaltung nach einem der Ansprüche 9 bis 13, welche weiter mindestens einen Widerstand (R1, R2, R3) aufweist, der zwischen die n-diffundierte Zone (120) und die p-diffundierte Zone (117) mindestens einer Diode der Darlington-Kette (142) geschaltet ist, um den Strom in den Dioden der Darlington-Diodenkette (142) abzugleichen und die Klemmenspannung für einen gemischten Spannungsbetrieb zu erhöhen.

**Revendications**

**1.** Un circuit de protection ESD (contre les pointes de tension) formé sur un substrat (102) comprenant :

- au moins un transistor npn latéral (104) pour lequel ledit substrat (102) sert de base (112), dans lequel ledit au moins un transistor npn latéral (104) est connecté entre un plot d'entrée/sortie (110) et la masse, ledit substrat (102) étant connecté à la masse ; et

- un circuit de polarisation de substrat (150) pour déclencher le ou chaque transistor npn latéral (104) par accroissement d'une tension sur la résistance du substrat (114) pendant l'occurrence d'une pointe de tension, ce circuit étant **caractérisé en ce que**

- ledit circuit de polarisation de substrat (150) comprend une chaîne de diodes Darlington (132, 142) connectée entre un plot d'entrée/sortie (110) et une tension d'alimentation (Vcc), dans laquelle au moins une diode de ladite chaîne de diodes Darlington (132, 142) comprend un transistor pnp vertical spécifique présentant un collecteur (128) connecté à la base (112) dudit transistor npn latéral (104) pour déclencher ledit transistor npn latéral (104) par l'intermédiaire de la résistance de substrat (114).

2. Le circuit de protection ESD selon la revendication 1, dans lequel ladite au moins une diode (116) comprend :

   - une région diffusée (117) de type p située dans une région de puits (118) et connectée à un plot d'entrée/sortie (110) ; et

   - une région diffusée (120) de type n située dans ladite région de puits (118) et connectée à une tension d'alimentation (Vcc).

3. Le circuit de protection ESD selon la revendication 2, comprenant en outre au moins un redresseur commandé à semiconducteur spécifique SCR (130) formé par ladite région diffusée de type p (117), ladite région de puits (118), ledit substrat (102) et une région d'émetteur (106) dudit transistor npn latéral (104).

4. Le circuit de protection ESD selon l'une des revendications précédentes, dans lequel ledit transistor npn latéral (104) comprend un émetteur (106) connecté à un potentiel de masse et un collecteur (108) connecté à un plot d'entrée/sortie (110).

5. Le circuit de protection ESD selon l'une des revendications précédentes, comprenant en outre une pluralité de transistors npn (104) comprenant chacun un collecteur connecté audit plot d'entrée/sortie (110), un émetteur connecté au potentiel de masse et une base connectée à ce potentiel de masse par l'intermédiaire d'une résistance spécifique (114) dans ce substrat.

6. Le circuit de protection ESD selon l'une des revendications précédentes, comprenant en outre une diode en inverse connectée en parallèle avec ladite chaîne de diodes Darlington (142) pour la réduction des fuites, ladite diode en inverse étant une partie d'un transistor (144).

7. Le circuit de protection ESD selon l'une des revendications précédentes, comprenant en outre au moins une résistance (R1, R2, R3) connectée entre un émetteur et une base d'au moins une diode de ladite chaîne de diodes Darlington (142).

8. Le circuit de protection ESD selon l'une des revendications précédentes, dans lequel ladite chaîne de diodes Darlington (142) comprend entre 2 et 12 diodes.

9. Le circuit de protection ESD selon l'une des revendications 5 à 8, **caractérisé en ce que** chacun des transistors de la pluralité de transistors npn latéraux comporte une région d'émetteur diffusée (106) connectée au potentiel de masse et une région de collecteur diffusée (108) connectée à un plot d'entrée/sortie (110).

10. Le circuit de protection ESD selon l'une des revendications précédentes, dans lequel chacune desdites diodes (116) de ladite chaîne de diodes Darlington (142) comprend un transistor pnp vertical spécifique (122).

11. Le circuit de protection ESD selon la revendication 10, dans lequel chacune des diodes de ladite chaîne de diodes Darlington (142) comprend :

    - une région de puits de type n (118) située dans ledit substrat (102), ladite région de puits de type n (118) formant une région de base (128) dudit transistor pnp vertical spécifique (122) ;

    - une région diffusée de type n (120) dans ladite région de puits de type n (118) pour fournir une connexion à ladite région de base (128) dudit transistor pnp vertical spécifique (122) ; et

    - une région diffusée de type p (117) dans ladite région de puits de type n (118), ladite région diffusée de type p (117) formant une région d'émetteur dudit transistor pnp vertical spécifique (122).

12. Le circuit de protection ESD selon l'une des revendications 9 à 11, comprenant en outre au moins un redresseur commandé à semiconducteur spécifique SCR (130) formé par ladite région diffusée de type p (117) et ladite région de puits (118) de l'une desdites diodes de ladite chaîne de diodes Darlington (142), ledit substrat (102) et une région diffusée d'émetteur (106) de l'un de ladite pluralité de transistors npn latéraux (104).

**13.** Le circuit de protection ESD selon l'une des revendications 9 à 12, comprenant en outre une diode en inverse connectée en parallèle avec lesdites diodes dans ladite chaîne de diodes Darlington (142), ladite diode en inverse étant une partie d'un transistor (144).

**14.** Le circuit de protection ESD selon l'une des revendications 9 à 13, comprenant en outre au moins une résistance (R1, R2, R3) connectée entre ladite région de type n diffusée (120) et ladite région de type p diffusée (117) d'au moins une diode de ladite chaîne de diodes Darlington (142) pour équilibrer le courant dans lesdites diodes de ladite chaîne de diodes Darlington (142) et pour augmenter la composante de tension continue pour un fonctionnement à tension adaptée.

PRIOR ART *Fig.1*

PRIOR ART *Fig.2*

*Fig.3*

*Fig.4*

*Fig.5*

Fig.6

Fig.11

Fig.7

Fig.9

Fig.8

Fig.10